# EUROPÄISCHE PATENTSCHRIFT

(11) **EP 1 381 907 B1**
(45) Veröffentlichungstag und Bekanntmachung des Hinweises auf die Patenterteilung: **21.12.2005**
(21) Anmeldenummer: 02761913.9
(22) Anmeldetag: 12.04.2002
(51) Int. Cl.: G02B 27/09, H01S 3/00

(54) **ANORDNUNG ZUR KOLLIMIERUNG DES VON EINER LASERLICHTQUELLE AUSGEHENDEN LICHTS SOWIE STRAHLTRANSFORMATIONSVORRICHTUNG FÜR EINE DERARTIGE ANORDNUNG**
DEVICE FOR COLLIMATING LIGHT EMANATING FROM A LASER LIGHT SOURCE AND BEAM TRANSFORMER FOR SAID ARRANGEMENT
DISPOSITIF DE COLLIMATION D'UNE LUMIERE EMISE PAR UNE SOURCE DE LUMIERE LASER ET TRANSFORMATEUR DE FAISCEAU CON U POUR CE DISPOSITIF

(30) Priorität: 18.04.2001 DE 10118788
(43) Veröffentlichungstag der Anmeldung: 21.01.2004
(73) Patentinhaber: Hentze-Lissotschenko Patentverwaltungs GmbH & Co.KG, 25870 Norderfriedrichskoog (DE)
(72) Erfinder: MIKHAILOV, Alexei, 44227 Dortmund (DE); BARTOSCHEWSKI, Daniel, 45883 Gelsenkirchen (DE)
(74) Vertreter: Basfeld, Rainer
(86) Internationale Anmeldenummer: PCT/EP2002/004081
(87) Internationale Veröffentlichungsnummer: WO 2002/084377

(56) Entgegenhaltungen:
- WO-A-99/35724
- DE-A- 19 813 127
- US-A- 4 185 891

## Beschreibung

Die vorliegende Erfindung betrifft eine Anordnung zur Kollimierung des von einer als Laserdiodenbarren ausgeführten Laserlichtquelle ausgehenden Lichts gemäß dem Oberbegriff des Anspruchs 1. Weiterhin betrifft die vorliegende Erfindung eine Strahltransformationsvorrichtung für eine derartige Anordnung.

Eine Anordnung der vorgenannten Art ist geeignet für die Kollimierung des von einem Laserdiodenbarren ausgehenden Lichts. Hierbei kann beispielsweise für die Kollimierung der Fast-Axis-Divergenz des von dem Laserdiodenbarren ausgehenden Lichts eine sich mit seiner Zylinderachse in Richtung der Reihe der nebeneinanderliegenden Emissionsquellen des Laserdiodenbarrens erstreckende Zylinderlinse verwendet werden. Für die Kollimierung der Slow-Axis-Divergenz des von dem Laserdiodenbarren ausgehenden Lichts kann ein Zylinderlinsenarray verwendet werden, das einzelne als Kollimationselemente dienende Zylinderlinsenabschnitte aufweist, deren Zylinderachsen senkrecht zur Richtung der Reihe der Emissionsquellen ausgerichtet ist. Da in der Regel die Emissionsquellen eines Laserdiodenbarrens äquidistant zueinander angeordnet sind und gleichzeitig auch die einzelnen Kollimationselemente eines derartigen Zylinderlinsenarrays äquidistant zueinander angeordnet sind, wird im Stand der Technik jeweils das von einer der Emissionsquellen ausgehende Licht von genau einem der Kollimationselemente hinsichtlich der Slow-Axis kollimiert. Aufgrund der Tatsache, dass bei sehr kleinen Abständen zwischen den einzelnen Emissionsquellen eines Laserdiodenbarrens dementsprechend auch die Abstände zwischen den einzelnen Kollimationselementen vergleichsweise klein gewählt werden müssen, ergeben sich daraus fertigungstechnische Probleme.

Eine Anordnung der eingangs genannten Art ist aus der DE-A-198 13 127 bekannt welche den Oberbegriff von Anspruch 1 offenbart. Bei der darin beschriebenen Vorrichtung ist in Strahlrichtung hinter den Emissionsquellen des Laserdiodenbarrens ein Zylinderlinsenarray für die Kollimierung der Slow-Axis-Divergenz vorgesehen. Dabei ist einer jeder der Emissionsquellen eine der Zylinderlinsen des Zylinderlinsenarrays zugeordnet.

Aus der US-A-4,185,891 ist eine Anordnung zur Kollimierung des von einer Laserlichtquelle ausgehenden Lichts bekannt. Die darin beschriebene Laserlichtquelle ist als Stapel von übereinander angeordneten Laserdioden ausgebildet. Jede der Laserdioden weist dabei nur eine Emissionsquelle auf. In Strahlrichtung hinter dem Stapel der Laserdioden ist ein Zylinderlinsenarray für die teilweise Kollimierung der Fast-Axis-Divergenz der Laserdioden vorgesehen. Die Zylinderachsen der Zylinderlinsen dieses Arrays sind senkrecht zu der Richtung ausgerichtet, in der die Laserdioden übereinander angeordnet sind. Dabei ist jeder der Laserdioden eine Zylinderlinse des Arrays zugeordnet. In Strahlrichtung hinter dem Zylinderlinsenarray ist beabstandet zu diesem eine erste einzelne Zylinderlinse angeordnet, deren Zylinderachse ebenfalls senkrecht zu der Richtung ausgerichtet ist, in der die Laserdioden übereinander angeordnet sind. Durch diese erste einzelne Zylinderlinse wird die Kollimierung der Fast-Axis-Divergenz komplettiert. Durch eine zweite einzelne Zylinderlinse, die in Strahlrichtung hinter der ersten angeordnet ist und deren Zylinderachse in der Richtung ausgerichtet ist, in der die Laserdioden übereinander angeordnet sind, wird die Slow-Axis-Divergenz kollimiert.

Das der vorliegenden Erfindung zugrundeliegende Problem ist die Schaffung einer Anordnung der eingangs genannten Art, die bei gleichem Abstand einzelner Emissionsquellen der Laserlichtquelle zueinander einen größeren Abstand der Kollimationselemente zueinander ermöglicht.

Dieses Problem wird erfindungsgemäß dadurch gelöst, dass die Anordnung eine Strahltransformationsvorrichtung umfasst, die jeweils das von mindestens zwei Emissionsquellen ausgehende Licht derart transformieren kann, dass das von diesen mindestens zwei Emissionsquellen ausgehende Licht auf genau ein Kollimationselement der Mehrzahl von Kollimationselementen auftrifft und kollimiert wird. Insbesondere wird jeweils das von genau zwei Emissionsquellen ausgehende Licht auf genau ein Kollimationselement auftreffen und von diesem kollimiert. Aufgrund dieser erfindungsgemäßen Strahltransformationsvorrichtung kann somit der Abstand der einzelnen Kollimationselemente doppelt so groß gewählt werden wie bei Anordnungen aus dem Stand der Technik, so dass die Fertigungskosten für eine erfindungsgemäße Anordnung deutlich niedriger liegen.

Erfindungsgemäß kann vorgesehen sein, dass die Kollimationsmittel mindestens eine Linse für die Kollimation der Fast-Axis-Divergenz umfassen, wobei hierbei die Strahltransformationsvorrichtung zwischen der vorgenannten mindestens einen für die Fast-Axis-Divergenz vorgesehenen Linse und den Kollimationselementen für die Slow-Axis-Divergenz angeordnet ist.

Gemäß einer bevorzugten Ausführungsform der vorliegenden Erfindung umfasst die Strahltransformationsvorrichtung eine strukturierte Eintrittsfläche und eine strukturierte Austrittsfläche, die derart gestaltet sind, dass die von benachbarten Emissionsquellen ausgehenden Lichtstrahlen in der Strahltransformationsvorrichtung jeweils paarweise aneinander angenähert werden. Je nach alternativen Ausführungsformen der erfindungsgemäßen Strahltransformationsvorrichtung können sich dabei die aneinander angenäherten Strahlen der Strahltransformationsvorrichtung kreuzen oder aber nur nahe beieinander aus der Austrittsfläche austreten, ohne sich vorher gekreuzt zu haben.

Erfindungsgemäß kann vorgesehen sein, dass die Eintrittsfläche und/oder die Austrittsfläche mit jeweils benachbart zueinander angeordneten, unterschiedlich gestalteten Zylinderlinsenabschnitten und/oder planen Abschnitten strukturiert sind, wobei deren Zylinderachsen sich insbesondere in einer Richtung erstrecken, die senkrecht zur Richtung der Reihe und zur mittleren Ausbreitungsrichtung der Lichtstrahlen ausgerichtet sind.

Zum einen dienen die an Eintritts- und Austrittsfläche vorgesehenen Zylinderlinsenabschnitte und/oder planen Abschnitte dazu, die Lichtstrahlen aneinander anzunähern, wobei diese Annäherung durch unterschiedliche Neigungen benachbarter Flächen der planen Abschnitte und/oder der Zylinderlinsenabschnitte bzw. zusätzlich insbesondere auch durch unterschiedliche Krümmungsradien benachbarter Zylinderlinsenabschnitte erzielt werden kann. Durch derartige Ausgestaltungen ergeben sich mit einfach zu realisierenden Mitteln die erfindungsgemäßen Vorteile einer Strahltransformationsvorrichtung, die insbesondere zwei Strahlen im wesentlichen derart aneinander annähert oder zusammenfasst, dass sie von einem Kollimationselement weiter kollimiert werden können.

Weiterhin wird durch die Verwendung der vorgenannten Zylinderlinsenabschnitte auf der Eintritts- und/oder der Austrittsfläche der Strahltransformationsvorrichtung eine gewisse Vorkollimation der durch die Strahltransformationsvorrichtung hindurchtretenden Lichtstrahlen bewirkt, so dass die in Strahlrichtung in der Regel dahinter angeordneten Kollimationselemente nur noch eine endgültige Kollimation herbeiführen müssen. Insbesondere müssen natürlich die nachfolgenden Kollimationselemente auf die in der Strahltransformationsvorrichtung vorgesehenen Zylinderlinsenabschnitte abgestimmt sein.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: eine schematische Seitenansicht einer ersten Ausführungsform einer erfindungsgemäßen Anordnung;
- Fig. 2: eine schematische Seitenansicht einer zweiten Ausführungsform einer erfindungsgemäßen Anordnung;
- Fig. 3a: eine schematische Seitenansicht einer dritten Ausführungsform einer erfindungsgemäßen Anordnung;
- Fig. 3b: eine Ansicht gemäß dem Pfeil IIIb in Fig. 3a.

In allen anliegenden Abbildungen sind zur besseren Übersichtlichkeit Koordinatenachsen eines kartesischen Koordinatensystems X, Y, Z eingezeichnet.

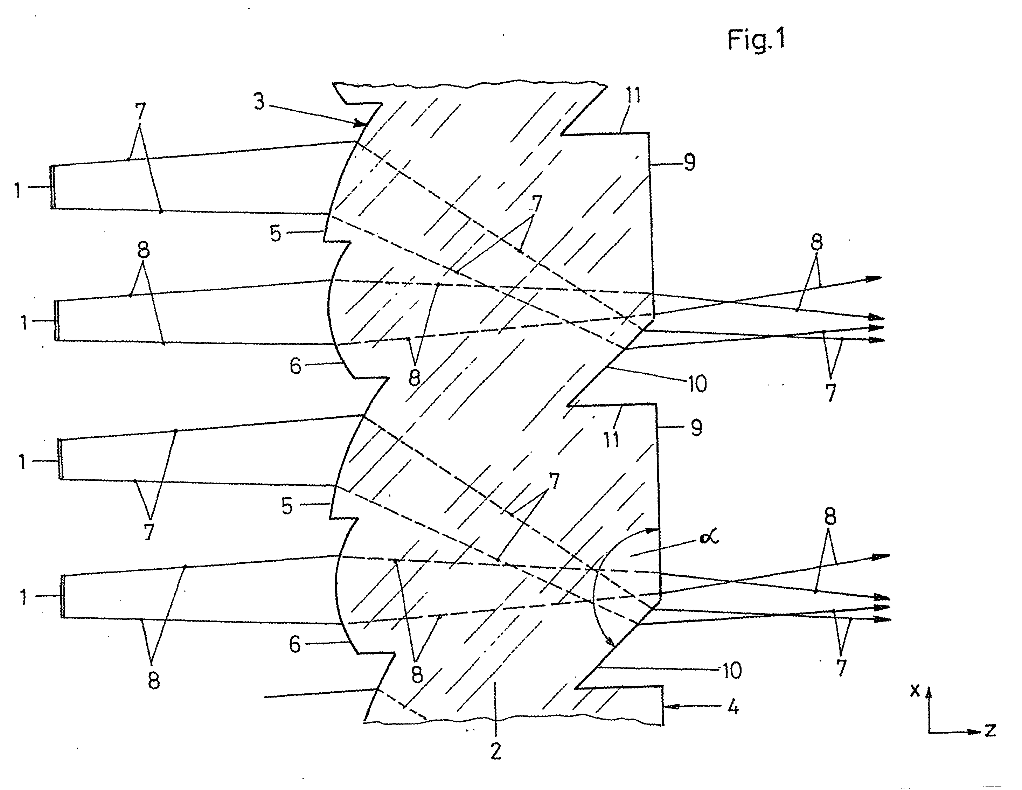

Aus Fig. 1 sind linienförmige Emissionsquellen 1 ersichtlich, die in einer Reihe angeordnet sind und ihrer Gesamtheit, die wesentlich mehr als die vier abgebildeten Emissionsquellen 1 umfassen kann, eine Laserlichtquelle, insbesondere einen Laserdiodenbarren darstellen. Weiterhin ist in Fig. 1 eine erste Strahltransformationsvorrichtung 2 abgebildet, die lediglich schematisch angedeutet ist und die sich nach oben und nach unten in Fig. 1 weiter fortsetzen kann. Die Strahltransformationsvorrichtung 2 umfasst eine strukturierte Eintrittsfläche 3 und eine strukturierte Austrittsfläche 4. Die Eintrittsfläche 3 umfasst einzelne Zylinderlinsenabschnitte 5, 6, die jeweils nebeneinander angeordnet sind und sich sowohl durch den Krümmungsradius ihrer Oberfläche als auch durch die Neigung ihrer Oberfläche gegenüber der mittleren Eintrittsrichtung Z der von den Emissionsquellen 1 ausgehenden Lichtstrahlen 7, 8 unterscheiden. In dem abgebildeten Ausführungsbeispiel erstrecken sich die Zylinderachsen der Zylinderlinsenabschnitte 5, 6 in Y-Richtung und somit aus der Zeichenebene der Fig. 1 heraus. Die Zylinderlinsenabschnitte 6 sind nicht oder nur kaum gegenüber der X-Richtung geneigt, so dass die durch die Zylinderlinsenabschnitte 6 in die Strahltransformationsvorrichtung 2 eintretenden Lichtstrahlen 8 im wesentlichen ihre ursprüngliche Richtung, die der Richtung Z entspricht, beibehalten. Dahingegen sind die jeweils neben den Zylinderlinsenabschnitte 6 angeordneten Zylinderlinsenabschnitte 5 gegenüber der X-Richtung geneigt, so dass die durch diese Zylinderlinsenabschnitte 5 in die Strahltransformationsvorrichtung 2 eintretenden Lichtstrahlen 7 an der Eintrittsfläche 3 in in Fig. 1 negativer X-Richtung abgelenkt werden.

Die der Eintrittsfläche 3 im wesentlichen gegenüberliegende Austrittsfläche 4 weist plane sich in der XY-Ebene erstreckende Abschnitte 9 sowie gegenüber diesen Abschnitten 9 unter einem Winkel α angeordnete plane Abschnitte 10 auf. In dem abgebildeten Ausführungsbeispiel beträgt der Winkel α zwischen den Abschnitten 9, 10 135°. Wie aus Fig. 1 ersichtlich ist, schließt sich jeweils an einen Abschnitt 9 ein zu diesem unter dem Winkel α verlaufender Abschnitt 10 an, der sich von dem Abschnitt 9 in die Strahltransformationsvorrichtung 2 hineinerstreckt. An dem von dem vorgenannten Abschnitt 9 abgewandten Ende des Abschnitts 10 ist in der Austrittsfläche 4 eine sich in Z-Richtung erstreckende Stufe 11 ausgebildet, die von dem Abschnitt 10 zu dem nächsten Abschnitt 9 nach außen führt.

Aus Fig. 1 ist weiterhin ersichtlich, dass die jeweils durch die Zylinderlinsenabschnitte 5 in die Strahltransformationsvorrichtung 2 eintretenden Lichtstrahlen 7 jeweils unterhalb eines Verbindungsbereichs zwischen zwei planen Abschnitten 9, 10 aus der Austrittsfläche 4 austreten, wohingegen die durch die Zylinderlinsenabschnitte 6 hindurchtretenden Lichtstrahlen 8 jeweils oberhalb des Verbindungsbereichs zwischen zwei planen Abschnitten 9, 10 austreten. Die Lichtstrahlen 7 kreuzen dabei innerhalb der Strahltransformationsvorrichtung 2 die Lichtstrahlen 8. Aufgrund der Tatsache, dass die Lichtstrahlen 7 jeweils aus einem planen Abschnitt 10 austreten, wohingegen die Lichtstrahlen 8 aus einem planen Abschnitt 9 austreten, der gegenüber dem jeweils benachbarten planen Abschnitt 10 um einen Winkel von 135° gekippt ist, erfahren die Lichtstrahlen 7 eine Brechung, die unterschiedlich ist zu der Brechung, die die Lichtstrahlen 8 an der Austrittsfläche 4 erfahren. Aus Fig. 1 ist ersichtlich, dass jeweils die oberhalb und unterhalb des Verbindungsbereichs zweier benachbarter planer Abschnitte 9, 10 austretenden Lichtstrahlen 7, 8 zum einen im wesentlichen im gleichen Raumbereich aus der Austrittsfläche 4 austreten und zum anderen im wesentlichen in die gleiche Richtung, nämlich etwa in Z-Richtung aus der Austrittsfläche 4 austreten.

Aufgrund dieser Zusammenfassung jeweils zweier Lichtstrahlen 7, 8, die von benachbarten Emissionsquellen 1 ausgehen, besteht die Möglichkeit, diese beiden durch die teilweise als Kollimationsmittel dienende Strahltransformationsvorrichtung 2 zusammengefassten Lichtstrahlen 7, 8 in ein als weiteres Kollimationsmittel dienendes Kollimationselement eines im nachfolgenden noch näher beschriebenen Linsenarrays für die Kollimation der Slow-Axis-Divergenz des von dem Laserdiodenbarren ausgehenden Lichts auftreffen zu lassen.

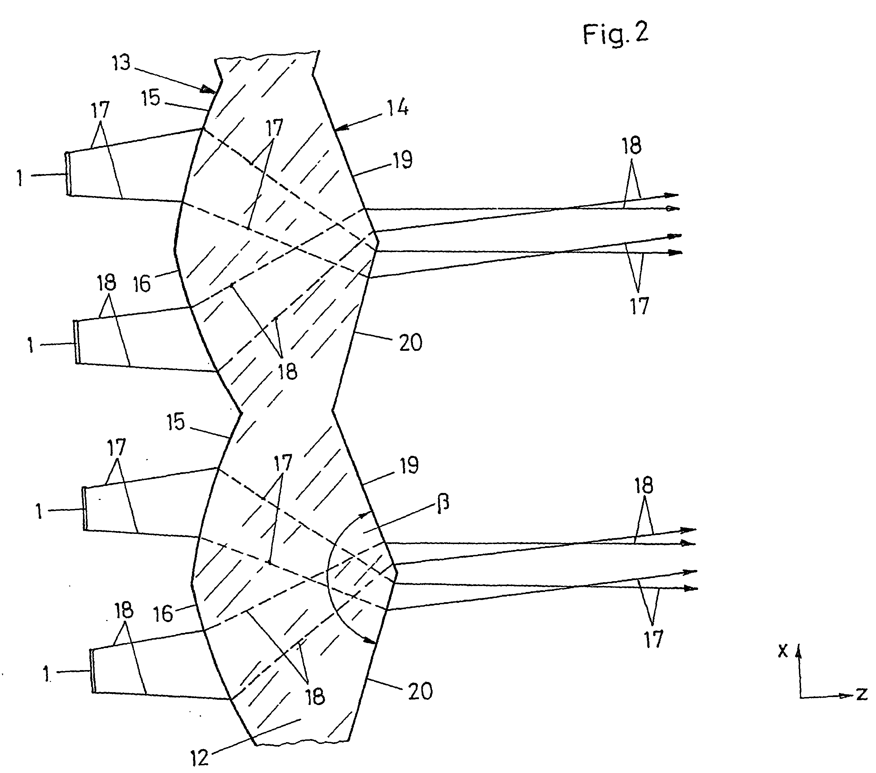

Aus Fig. 2 ist eine weitere erfindungsgemäße Anordnung ersichtlich, die eine anders gestaltete Strahltransformationsvorrichtung 12 umfasst. Diese Strahltransformationsvorrichtung 12 weist ebenfalls eine Eintrittsfläche 13 und eine dieser gegenüberliegende Austrittsfläche 14 auf. Die Eintrittsfläche 13 umfasst ebenfalls jeweils nebeneinander angeordnete Zylinderlinsenabschnitte 15, 16, deren Zylinderachsen sich in Y-Richtung und somit aus der Zeichenebene von Fig. 2 heraus erstrecken. In dem in Fig. 2 abgebildeten Ausführungsbeispiel weisen die Zylinderlinsenabschnitte 15, 16 im wesentlichen die gleiche Krümmung auf und sind um den gleichen absoluten Winkel gegenüber der X-Richtung gekippt, allerdings mit unterschiedlichen Vorzeichen. Aufgrund dieser unterschiedlichen Verkippung der Zylinderlinsenabschnitte 15, 16 gegenüber der X-Richtung wird der durch den Zylinderlinsenabschnitt 15 eintretende Lichtstrahl 17 in der Strahltransformationsvorrichtung 12 in Fig. 2 nach unten abgelenkt, wohingegen der durch den Zylinderlinsenabschnitt 16 eintretende Lichtstrahl 18 in der Strahltransformationsvorrichtung 12 nach oben abgelenkt wird. Die beiden vorgenannten Lichtstrahlen 17, 18 kreuzen einander in der Strahltransformationsvorrichtung 12 kurz vor Erreichen der Austrittsfläche 14.

Die Austrittsfläche 14 umfasst ähnlich wie die in Fig. 1 abgebildete Austrittsfläche 4 plane Abschnitte 19, 20, die jeweils einen Winkel β von 135° miteinander einschließen. Wie aus Fig. 2 ersichtlich ist, treffen die Lichtstrahlen 17 jeweils kurz unterhalb des Verbindungsbereichs der planen Abschnitte 19, 20 auf den planen Abschnitt 20, wohingegen die Lichtstrahlen 18 jeweils kurz oberhalb des Verbindungsbereichs der beiden planen Abschnitte 19, 20 auf den planen Abschnitt 19 auftreffen. Aufgrund der Tatsache, dass die planen Abschnitte 19, 20 einen Winkel β von beispielsweise 135° miteinander einschließen, werden die Lichtstrahlen 17, 18 an den planen Abschnitten 19, 20 unterschiedlich gebrochen, so dass sie zum einen im wesentlichen im gleichen Raumbereich und zum anderen im wesentlichen in die gleiche Richtung, die im Mittel der Z-Richtung entspricht, die Strahltransformationsvorrichtung 12 verlassen.

Wie im Zusammenhang mit dem in Fig. 1 abgebildeten Ausführungsbeispiel erwähnt, werden auch bei dem Ausführungsbeispiel gemäß Fig. 2 durch die teilweise als Kollimationsmittel dienende Strahltransformationsvorrichtung 12 zwei benachbarte Lichtstrahlen 17, 18 derart zusammengefasst, dass sie auf ein im nachfolgenden noch näher beschriebenes als weiteres Kollimationsmittel dienendes Kollimationselement auftreffen können.

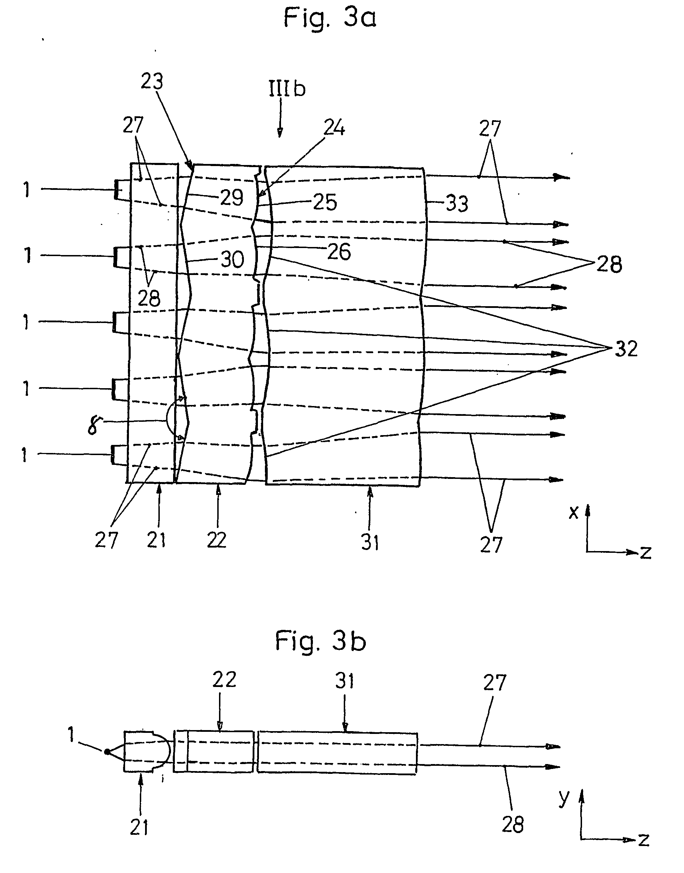

Aus Fig. 3 ist eine dritte Ausführungsform einer erfindungsgemäßen Anordnung abgebildet, bei der eine als Kollimationsmittel dienende Linse 21 für die Kollimation der Fast-Axis-Divergenz zwischen den Emissionsquellen 1 und einem dritten Ausführungsbeispiel einer erfindungsgemäßen Strahltransformationsvorrichtung 22 angeordnet ist. Die Linse 21 ist in dem abgebildeten Ausführungsbeispiel als plankonvexe Zylinderlinse ausgebildet, deren Zylinderachse sich in X-Richtung und somit in Richtung der Reihe der nebeneinanderliegenden Emissionsquellen 1 erstreckt. Durch diese Linse 21 findet eine Kollimation der bei Laserdiodenbarren auftretenden Fast-Axis-Divergenz statt.

Die Strahltransformationsvorrichtung 22 weist ebenfalls eine Eintrittsfläche 23 und eine Austrittsfläche 24 auf, wobei allerdings bei der Strahltransformationsvorrichtung 22 die Austrittsfläche 24 Zylinderlinsenabschnitte 25, 26 umfasst, wohingegen die Eintrittsfläche 23 für die Brechung der Lichtstrahlen 27, 28.plane Abschnitte 29, 30 umfasst, die jeweils einen Winkel γ miteinander einschließen, der in dem abgebildeten Ausführungsbeispiel etwa 157,5° beträgt. Gleichzeitig schließen die beiden planen Abschnitte 29, 30 mit der X-Richtung einen Winkel von etwa 12,5° beziehungsweise etwa -12,5° ein. Wie aus Fig. 3a ersichtlich ist, treffen bei der erfindungsgemäßen Anordnung jeweils von benachbarten Emissionsquellen 1 ausgehende Lichtstrahlen 27, 28 auf benachbarte plane Abschnitte 29, 30 auf. Aufgrund deren Neigung zueinander beziehungsweise deren Neigung zur X-Richtung werden die Lichtstrahlen 27, 28 an der Eintrittsfläche 23 derart gebrochen, dass sie sich innerhalb der Strahltransformationsvorrichtung 22 aufeinander zu bewegen. Weiterhin ist jedoch zum einen der Winkel zwischen den planen Abschnitten 29, 30 so gestaltet und gleichzeitig die Strahltransformationsvorrichtung in Ausbreitungsrichtung, also in Z-Richtung, so kurz, dass die Lichtstrahlen 27, 28 benachbarter Emissionsquellen 1 sich in der Strahltransformationsvorrichtung 22 nicht kreuzen. Vielmehr trifft der Lichtstrahlen 27 jeweils oberhalb des Verbindungsbereichs zweier benachbarter Zylinderlinsenabschnitte 25, 26 auf den Zylinderlinsenabschnitt 25, wohingegen der Lichtstrahl 28 unterhalb des Verbindungsbereichs der Zylinderabschnitte 25, 26 auf den Zylinderlinsenabschnitt 26 auftrifft. Die Zylinderlinsenabschnitte 25, 26 weisen jeweils die gleiche Brennweite auf, wobei sich ihre Zylinderachsen in Y-Richtung, und damit aus der Zeichenebene von Fig. 3a heraus erstrecken. Die Zylinderlinsenabschnitte 25, 26 sind jeweils leicht gegeneinander und gegen die X-Richtung geneigt, so dass die durch sie hindurchtretenden Strahlen 27, 28 nach Austritt aus der Austrittsfläche 24 eng benachbart zueinander etwa in die gleiche Richtung, nämlich in die Z-Richtung austreten, wobei die beiden Strahlen 27, 28 auch nach Austritt aus der Strahltransformationsvorrichtung 22 noch leicht aufeinander zulaufen. Jeweils einander gegenüberliegende und zusammenwirkende plane Abschnitte 29, 30 und Zylinderlinsenabschnitte 25, 26 sind derart zueinander ausgerichtet, dass die aus der Austrittsfläche 24 austretenden Lichtstrahlen 27, 28 auf einen gemeinsamen Brennpunkt fokussieren, der in Z-Richtung weit hinter dem im folgenden noch näher beschriebenen Linsenarray 31 angeordnet sind. Die Strahltransformationsvorrichtung 22 dient somit teilweise als Kollimationsmittel für die Lichtstrahlen 27, 28, weil die Slow-Axis-Divergenz nach Durchtritt durch die Strahltransformationsvorrichtung 22 aufgehoben ist, derart, dass die Strahlen auf einen in Z-Richtung weit entfernten Brennpunkt fokussieren.

In Fig. 3 ist weiterhin das als weiteres Kollimationsmittel dienende Linsenarray 31 eingezeichnet, das in Z-Richtung hinter der Strahltransformationsvorrichtung 22 angeordnet ist und auf seiner der Strahltransformationsvorrichtung 22 zugewandten Seite jeweils Zylinderlinsenabschnitte 32 gleicher Brennweite mit in Y-Richtung ausgerichteten Zylinderachsen umfasst. Diese Zylinderlinsenabschnitte 32 bilden jeweils Kollimationselemente für zwei aus nebeneinander liegenden Zylinderlinsenabschnitten 25, 26 der Strahltransformationsvorrichtung 22 austretende auf den vorgenannten Brennpunkt fokussierte Lichtstrahlen 27, 28. Dabei sind die Zylinderlinsenabschnitte 32 konkav ausgeführt, so dass die leicht fokussierten Lichtstrahlen 27, 28 wieder aufgeweitet werden. Auf der gegenüberliegenden Austrittsfläche des Linsenarrays 31 können weiterhin konvexe Zylinderlinsenabschnitte 33 vorgesehen sein, die in Fig. 3a ebenfalls eingezeichnet sind.

Aus Fig. 3a ist ersichtlich, dass die jeweils durch derartige Zylinderlinsenabschnitte 32, 33 gebildeten Kollimationselemente die durch sie hindurchtretenden Lichtstrahlen 27, 28 zusammen mit der Strahltransformationsvorrichtung 22 derart hinsichtlich der Slow-Axis-Divergenz kollimieren, dass die Lichtstrahlen 27, 28 nach dem Austritt aus dem Linsenarray 31 hinsichtlich der X-Richtung im wesentlichen parallel zueinander verlaufen.

Anstelle der in den vorgenannten Ausführungsbeispielen erwähnten Zylinderlinsenabschnitte 5, 6, 15, 16, 25, 26 können natürlich auch zylinderlinsenähnliche Abschnitte beispielsweise mit asphärischer Kontur verwendet werden. Weiterhin können auch bei den in Fig. 1 und 2 abgebildeten erfindungsgemäßen Anordnungen Linsen für die Kollimation der Fast-Axis-Divergenz zwischen den Emissionsquellen 1 und den jeweiligen Strahltransformationsvorrichtungen 2, 12 angeordnet werden. Weiterhin kann das aus den Strahltransformationsvorrichtungen 2, 12 austretende Licht entsprechend in Kollimationselemente für die Slow-Axis-Divergenz eintreten.

Das aus den entsprechenden Kollimationselementen austretende Licht kann mit aus dem Stand der Technik bekannten Mitteln beispielsweise auf das Eintrittsende einer Lichtleitfaser fokussiert werden.

## Patentansprüche

1. Anordnung zur Kollimierung des von einer Laserlichtquelle ausgehenden Lichts, umfassend
- eine als Laserdiodenbarren ausgeführte Laserlichtquelle mit einer Vielzahl von in mindestens einer Reihe nebeneinander angeordneten, im wesentlichen linienförmigen Emissionsquellen (1) sowie
- Kollimationsmittel, die ein Zylinderlinsenarray (31) mit als Kollimationselementen für die Kollimation der Slow-Axis-Divergenz dienenden Zylinderlinsenabschnitten (32, 33) umfassen, die in einer der Reihe der Emissionsquellen entsprechenden Richtung (X) nebeneinander angeordnet sind und deren Zylinderachsen sich in einer Richtung (Y) erstrecken, die senkrecht zur Richtung der Reihe und zur mittleren Ausbreitungsrichtung der Lichtstrahlen (7, 8, 17, 18, 27, 28) ausgerichtet ist, wobei die Kollimationselemente das von den Emissionsquellen ausgehende Licht in einer der Richtung der Reihe entsprechenden Richtung (X) kollimieren können,
**dadurch gekennzeichnet, dass**
- die Anordnung eine Strahltransformationsvorrichtung (2, 12,22) umfasst welche zwischen den Emissionsquellen (1) und dem Zylinderlinsenarray (31) angeordnet ist und die jeweils das von mindestens zwei Emissionsquellen (1) ausgehende Licht derart transformieren kann, dass das von diesen mindestens zwei Emissionsquellen (1) ausgehende Licht auf genau ein Kollimationselement der Mehrzahl von Kollimationselementen des Zylinderlinsenarrays (31) auftrifft und kollimiert wird.

2. Anordnung nach Anspruch 1, **dadurch gekennzeichnet, dass** die Strahltransformationsvorrichtung (2, 12, 22) das jeweils von zwei Emissionsquellen (1) ausgehende Licht derart transformieren kann, dass das von diesen beiden Emissionsquellen (1) ausgehende Licht auf genau ein Kollimationselement auftrifft und kollimiert wird.

3. Anordnung nach einem der Ansprüche 1 oder 2, **dadurch gekennzeichnet, dass** die Kollimationsmittel mindestens eine Linse (21) für die Kollimation der Fast-Axis-Divergenz umfassen.

4. Anordnung nach Anspruch 3, **dadurch gekennzeichnet, dass** die Strahltransformationsvorrichtung (2, 12, 22) zwischen der mindestens einen Linse (21) für die Fast-Axis-Divergenz und den Kollimationselementen für die Slow-Axis-Divergenz angeordnet ist.

5. Anordnung nach einem der Ansprüche 1 bis 4, **dadurch gekennzeichnet, dass** die Strahltransformationsvorrichtung (2, 12, 22) eine strukturierte Eintrittsfläche (3, 13, 23) und eine strukturierte Austrittsfläche (4, 14, 24) umfasst, die derart gestaltet sind, dass die von benachbarten Emissionsquellen (1) ausgehenden Lichtstrahlen (7, 8, 17, 18, 27, 28) in der Strahltransformationsvorrichtung (2, 12, 22) jeweils paarweise aneinander angenähert werden.

6. Anordnung nach Anspruch 5, **dadurch gekennzeichnet, dass** die Eintrittsfläche (3, 13, 23) und/oder die Austrittsfläche (4, 14, 24) mit jeweils benachbart zueinander angeordneten, unterschiedlich gestalteten Zylinderlinsenabschnitten (5, 6, 15, 16, 25, 26) und/oder planen Abschnitten (9, 10, 19, 20, 29, 30) strukturiert sind, wobei deren Zylinderachsen sich insbesondere in einer Richtung (Y) erstrecken, die senkrecht zur Richtung der Reihe und zur mittleren Ausbreitungsrichtung der Lichtstrahlen (7, 8, 17, 18, 27, 28) ausgerichtet sind.

7. Anordnung nach Anspruch 6, **dadurch gekennzeichnet, dass** auf der Eintrittsfläche (3, 13) Zylinderlinsenabschnitte (5, 6, 15, 16) vorgesehen sind, wogegen auf der Austrittsfläche (4, 14) plane Abschnitte (9, 10, 19, 20) vorgesehen sind.

8. Anordnung nach Anspruch 7, **dadurch gekennzeichnet, dass** jeweils zueinander benachbarte Zylinderlinsenabschnitte (5, 6) der Eintrittsfläche (3) einen unterschiedlichen Krümmungsradius sowie eine unterschiedliche Neigung gegenüber der mittleren Eintrittsrichtung der von den Emissionsquellen (1) ausgehenden Lichtstrahlen (7, 8) aufweisen.

9. Anordnung nach Anspruch 7, **dadurch gekennzeichnet, dass** die Zylinderlinsenabschnitte (15, 16) der Eintrittsfläche (13) einen gleichen Krümmungsradius und unterschiedliche Neigung zu der mittleren Eintrittsrichtung der von den Emissionsquellen (1) ausgehenden Lichtstrahlen (17, 18) aufweisen.

10. Anordnung nach einem der Ansprüche 7 bis 9, **dadurch gekennzeichnet, dass** jeweils in der der Richtung der Reihe der Emissionsquellen (1) entsprechenden Richtung (X) zueinander benachbarte plane Abschnitte (9, 10, 19, 20) der Austrittsfläche (4, 14) einen Winkel (α, β) miteinander einschließen und somit eine unterschiedliche Neigung zu der Austrittsrichtung der durch die Strahltransformationsvorrichtung (2, 12) hindurchtretenden Lichtstrahlen (7, 8, 17, 18) aufweisen.

11. Anordnung nach einem der Ansprüche 1 bis 10, **dadurch gekennzeichnet, dass** die jeweils durch benachbarte Zylinderlinsenabschnitte (5, 6, 15, 16) eintretenden Lichtstrahlen (7, 8, 17, 18) einander im Innern der Strahltransformationsvorrichtung (2, 12) kreuzen und durch zueinander benachbarter plane Abschnitte (9, 10, 19, 20) auf der gegenüberliegenden Seite der Strahltransformationsvorrichtung (2, 12) verlassen.

12. Anordnung nach Anspruch 6, **dadurch gekennzeichnet, dass** auf der Eintrittsfläche (23) jeweils paarweise in einer der Richtung der Reihe entsprechenden Richtung (X) benachbarte plane Abschnitte (29, 30) angeordnet sind, die einen Winkel (γ) miteinander einschließen.

13. Anordnung nach Anspruch 12, **dadurch gekennzeichnet, dass** auf der Austrittsfläche (24) der Strahltransformationsvorrichtung (22) in einer der Richtung der Reihe entsprechenden Richtung (X) Zylinderlinsenabschnitte (25, 26) nebeneinander angeordnet sind, deren Krümmungsradien gleich sind und die leicht gegeneinander geneigt sind.

14. Strahltransformationsvorrichtung für eine Anordnung nach einem der Ansprüche 1 bis 13, **gekennzeichnet durch** die die Strahltransformationsvorrichtung (2, 12, 22) betreffenden Merkmale eines oder mehrerer der Ansprüche 1 bis 13.

## Claims

1. Arrangement for collimation of the light originating from a laser light source, comprising
- a laser light source which is in the form of laser diode bars with a large number of essentially linear emission sources (1) arranged alongside one another in at least one row, and
- collimation means, which comprise a cylindrical lens array (31) with cylindrical lens sections (32, 33) which are used as collimation elements for the collimation of the slow axis divergence, are arranged alongside one another in a direction (X) corresponding to the row of emission sources and whose cylinder axes extend in a direction (Y) which is aligned at right angles to the direction of the row and to the mean propagation direction of the light beams (7, 8, 17, 18, 27, 28), in which case the collimation elements can collimate the light originating from the emission sources in a direction (X) which corresponds to the direction of the row,
**characterized in that**
- the arrangement comprises a beam transformation apparatus (2, 12, 22) which is arranged between the emission sources (1) and the cylindrical lens array (31) and can in each case transform the light originating from at least two emission sources (1) in such a way that the light originating from these at least two emission sources (1) strikes one and only one collimation element in the plurality of collimation elements in the cylindrical lens array (31) and is collimated.

2. Arrangement according to Claim 1, **characterized in that** the beam transformation apparatus (2, 12, 22) can transform the light which in each case originates from two emission sources (1) in such a way that the light which originates from these two emission sources (1) strikes one and only one collimation element, and is collimated.

3. Arrangement according to one of Claims 1 and 2, **characterized in that** the collimation means comprise at least one lens (21) for the collimation of the fast axis divergence.

4. Arrangement according to Claim 3, **characterized in that** the beam transformation apparatus (2, 12, 22) is arranged between the at least one lens (21) for the fast axis divergence and the collimation elements for the slow axis divergence.

5. Arrangement according to one of Claims 1 to 4, **characterized in that** the beam transformation apparatus (2, 12, 22) comprises a structured inlet surface (3, 13, 23) and a structured outlet surface (4, 14, 24), which are designed such that the light beams (7, 8, 17, 18, 27, 28) which originate from adjacent emission sources (1) in each case approach one another in pairs in the beam transformation apparatus (2, 12, 22).

6. Arrangement according to Claim 5, **characterized in that** the inlet surface (3, 13, 23) and/or the outlet surface (4, 14, 24) are/is structured with cylindrical lens sections (5, 6, 15, 16, 25, 26), which are in each case arranged adjacent to one another and are of different shape, and/or with planar sections (9, 10, 19, 20, 29, 30), with their cylinder axes extending in particular in a direction (Y) and being aligned at right angles to the direction of the row and to the mean propagation direction of the light beams (7, 8, 17, 18, 27, 28).

7. Arrangement according to Claim 6, **characterized in that** cylindrical lens sections (5, 6, 15, 16) are provided on the inlet surface (3, 13), while in contrast planar sections (9, 10, 19, 20) are provided on the outlet surface (4, 14).

8. Arrangement according to Claim 7, **characterized in that** respectively mutually adjacent cylindrical lens sections (5, 6) of the inlet surface (3) have a different radius of curvature and a different inclination with respect to the mean inlet direction of the light beams (7, 8) originating from the emission sources (1).

9. Arrangement according to Claim 7, **characterized in that** the cylindrical lens sections (15, 16) of the inlet surface (13) have the same radius of curvature and a different inclination with respect to the mean inlet direction of the light beams (17, 18) originating from the emission sources (1).

10. Arrangement according to one of Claims 7 to 9, **characterized in that** planar sections (9, 10, 19, 20) of the outlet surface (4, 14) which are in each case adjacent to one another in the direction (X) corresponding to the direction of the row of the emission sources (1) include an angle (α,β) with one another, and thus have a different inclination with respect to the emission direction of the light beams (7, 8, 17, 18) which pass through the beam transformation apparatus (2, 12).

11. Arrangement according to one of Claims 1 to 10, **characterized in that** the light beams (7, 8, 17, 18) which in each case enter through adjacent cylindrical lens sections (5, 6, 15, 16) cross one another in the interior of the beam transformation apparatus (2, 12) and leave through mutually adjacent planar sections (9, 10, 19, 20) on the opposite side of the beam transformation apparatus (2, 12).

12. Arrangement according to Claim 6, **characterized in that** planar sections (29, 30) which are in each case adjacent in pairs in a direction (X) corresponding to the direction of the row and include an angle (γ) with one another are arranged on the inlet surface (23).

13. Arrangement according to Claim 12, **characterized in that** cylindrical lens sections (25, 26) are arranged alongside one another on the outlet surface (24) of the beam transformation apparatus (22) in a direction (X) corresponding to the direction of the row, which cylindrical lens sections (25, 26) have the same radii of curvature and are slightly inclined with respect to one another.

14. Beam transformation apparatus for an arrangement according to one of Claims 1 to 13, **characterized by** the features which relate to the beam transformation apparatus (2, 12, 22) of one or more of Claims 1 to 13.

## Revendications

1. Arrangement pour collimater la lumière sortant d'une source de lumière laser comprenant
- une source de lumière laser réalisée sous la forme de barres de diodes laser comprenant une pluralité de sources d'émission (1) essentiellement de forme linéaire disposées les unes à côté des autres en au moins une rangée ainsi que
- des moyens de collimation qui comprennent un réseau de lentilles cylindriques (31) avec des sections de lentille cylindrique (32, 33) faisant office d'éléments de collimation servant à la collimation de la divergence de l'axe lent, lesquelles sont disposées les unes à côté des autres dans une direction (X) correspondant à la rangée de sources d'émission et dont les axes de cylindre s'étendent dans une autre direction (Y) qui est orientée perpendiculairement à la direction de la rangée et à la direction de propagation centrale des rayons de lumière (7, 8, 17, 18, 27, 28), les éléments de collimation pouvant collimater la lumière sortant des sources d'émission dans une direction correspondant à la direction (X) de la rangée,
**caractérisé en ce que**
- l'arrangement comprend un dispositif de transformation de rayon (2, 12, 22) qui est disposé entre les sources d'émission (1) et le réseau de lentilles cylindriques (31) et qui peut transformer la lumière qui sort à chaque fois d'au moins deux sources d'émission (1) de telle sorte que la lumière sortant de ces au moins deux sources d'émission (1) vienne frapper au moins un élément de collimation de la pluralité d'éléments de collimation du réseau de lentilles cylindriques (31) et soit collimatée.

2. Arrangement selon la revendication 1, **caractérisé en ce que** le dispositif de transformation de rayon (2, 12, 22) peut transformer la lumière qui sort à chaque fois d'au moins deux sources d'émission (1) de telle sorte que la lumière sortant de ces deux sources d'émission (1) vienne frapper exactement un élément de collimation et soit collimatée.

3. Arrangement selon l'une des revendications 1 ou 2, **caractérisé en ce que** les moyens de collimation comprennent au moins une lentille (21) pour la collimation de la divergence de l'axe rapide.

4. Arrangement selon la revendication 3, **caractérisé en ce que** le dispositif de transformation de rayon (2, 12, 22) est disposé entre l'au moins une lentille (21) pour la divergence de l'axe rapide et les éléments de collimation pour la divergence d l'axe lent.

5. Arrangement selon l'une des revendications 1 à 4, **caractérisé en ce que** le dispositif de transformation de rayon (2, 12, 22) comprend une surface d'entrée structurée (3, 13, 23) et une surface de sortie structurée (4, 14, 24) qui sont configurées de telle sorte que les rayons de lumière (7, 8, 17, 18, 27, 28) qui sortent des sources d'émission (1) voisines sont à chaque fois rapprochées par paires dans le dispositif de transformation de rayon (2, 12, 22).

6. Arrangement selon la revendication 5, **caractérisé en ce que** la surface d'entrée (3, 13, 23) et/ou la surface de sortie (4, 14, 24) sont structurées avec des sections de lentille cylindrique (5, 6, 15, 16, 25, 26) et/ou des sections planes (9, 10, 19, 20, 29, 30) à chaque fois disposées les unes à côté des autres et ayant des configurations différentes, leurs axes de cylindre s'étendant notamment dans une direction (Y) qui est orientée perpendiculairement à la direction de la rangée et à la direction de propagation centrale des rayons de lumière (7, 8, 17, 18, 27, 28).

7. Arrangement selon la revendication 6, **caractérisé en ce que** des sections de lentille cylindrique (5, 6, 15, 16) sont prévues sur la surface d'entrée (3, 13), alors que des sections planes (9, 10, 19, 20) sont prévues sur la surface de sortie (4, 14).

8. Arrangement selon la revendication 7, **caractérisé en ce que** les sections de lentille cylindrique (5, 6) à chaque fois voisines l'une de l'autre de la surface d'entrée (3) présentent un rayon de courbure différent ainsi qu'une inclinaison différente par rapport à la direction d'entrée centrale des rayons de lumière (7, 8) sortant des sources d'émission (1).

9. Arrangement selon la revendication 7, **caractérisé en ce que** les sections de lentille cylindrique (15, 16) de la surface d'entrée présentent un rayon de courbure différent ainsi qu'une inclinaison différente par rapport à la direction d'entrée centrale des rayons de lumière (17, 18) sortant des sources d'émission (1).

10. Arrangement selon l'une des revendications 7 à 9, **caractérisé en ce que** les surfaces planes (9, 10, 19, 20) de la surface de sortie (4, 14) voisines les unes des autres dans la direction (X) correspondant à la rangée de sources d'émission (1) incluent entre elles un angle (□, ß) et présentent ainsi une inclinaison différente par rapport à la direction de sortie des rayons de lumière (7, 8, 17, 18) qui traversent le dispositif de transformation de rayon (2, 12).

11. Arrangement selon l'une des revendications 1 à 10, **caractérisé en ce que** les rayons de lumière (7, 8, 17, 18) qui pénètrent à chaque fois à travers des sections de lentille cylindrique voisines (5, 6, 15, 16) se croisent entre eux à l'intérieur du dispositif de transformation de rayon (2, 12) et quittent le dispositif de transformation de rayon (2, 12) à travers des sections planes (9, 10, 19, 20) voisines les unes des autres sur le côté opposé.

12. Arrangement selon la revendication 6, **caractérisé en ce que** sur la surface d'entrée (23) sont disposées à chaque fois par paires dans une direction correspondant à la direction de la rangée (X) des sections planes voisines (29, 30) qui incluent entre elles un angle (γ).

13. Arrangement selon la revendication 12, **caractérisé en ce que** sur la surface de sortie (24) du dispositif de transformation de rayon (22) sont disposées les unes à côté dans une direction correspondant à la direction de la rangée (X) des autres des sections de lentille cylindrique (25, 26) dont les rayons de courbure sont égaux et qui sont légèrement inclinées les unes par rapport aux autres.

14. Dispositif de transformation de rayon pour un arrangement selon l'une des revendications 1 à 13, **caractérisé par** les caractéristiques de l'une ou de plusieurs des revendications 1 à 13 concernant le dispositif de transformation de rayon (2, 12, 22).
